(19) **Europäisches Patentamt European Patent Office Office européen des brevets**

(11) **EP 3 989 299 B1**

(12) **EUROPEAN PATENT SPECIFICATION**

(45) Date of publication and mention
of the grant of the patent:
**06.08.2025 Bulletin 2025/32**

(51) International Patent Classification (IPC):
**H10N 30/853** (2023.01)   **H10N 30/072** (2023.01)
**H10N 30/30** (2023.01)

(21) Application number: **20203952.5**

(52) Cooperative Patent Classification (CPC):
**H10N 30/073; H10N 30/306; H10N 30/8542**

(22) Date of filing: **26.10.2020**

(54) **PIEZOELECTRIC DEVICE COMPRISING FLEXIBLE SINGLE CRYSTALLINE PIEZOELECTRIC LINBO3 AND/OR LITAO3 FILMS INTEGRATED ON FLEXIBLE SUBSTRATE AND METHODS FOR PRODUCING THE SAME**

PIEZOELEKTRISCHE VORRICHTUNG MIT AUF EINEM FLEXIBLEN SUBSTRAT INTEGRIERTEN FLEXIBLEN EINKRISTALLINEN PIEZOELEKTRISCHEN LINBO3- UND/ODER LITAO3-FILMEN UND VERFAHREN ZU DEREN HERSTELLUNG

DISPOSITIF PIÉZO-ÉLECTRIQUE COMPRENANT DES FILMS PIÉZO-ÉLECTRIQUES LINBO3 ET/ OU LITAO3 MONOCRISTALLINS FLEXIBLES INTÉGRÉS SUR UN SUBSTRAT FLEXIBLE ET PROCÉDÉS DE FABRICATION ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.04.2022 Bulletin 2022/17**

(73) Proprietors:
• **Université de Franche-Comté**
  **25000 Besançon (FR)**
• **École Nationale Supérieure de Mécanique et des Microtechniques**
  **25000 Besançon (FR)**

(72) Inventors:
• **BARTASYTE, Ausrine**
  **25870 Châtillon-le-duc (FR)**
• **MARGUERON, Samuel**
  **25870 Châtillon-le-duc (FR)**
• **GAUTHIER-MANUEL, Ludovic**
  **25000 Besançon (FR)**
• **CLEMENTI, Giacomo**
  **25000 Besançon (FR)**

• **OUHABAZ, Merieme**
  **25000 Besançon (FR)**
• **BASSIGNOT, Florent**
  **25000 Besançon (FR)**

(74) Representative: **Vidon Brevets & Stratégie**
  **16B, rue de Jouanet**
  **BP 90333**
  **35703 Rennes Cedex 7 (FR)**

(56) References cited:
JP-A- H11 136 964      US-A1- 2003 199 105
US-A1- 2018 294 793    US-A1- 2018 316 329
US-A1- 2019 190 404

• **CLEMENTI GIACOMO ET AL: "LiNbO3 films - A low-cost alternative lead-free piezoelectric material for vibrational energy harvesters", MECHANICAL SYSTEMS AND SIGNAL PROCESSING, ELSEVIER, AMSTERDAM, NL, vol. 149, 29 August 2020 (2020-08-29), XP086336053, ISSN: 0888-3270, [retrieved on 20200829], DOI: 10.1016/J.YMSSP.2020.107171**

## Description

### 1. Domain

The invention relates to a piezoelectric device and method of manufacturing the same. More specifically, the invention relates to a flexible piezoelectric device with good impedance while ensuring stability and feasibility of industrial manufacturing.

### 2. Prior Art

Energy harvesting has the potential to achieve long-life stand-alone operations of wireless sensor networks, wearable devices, and medical implants. This has therefore attracted considerable interest from academia and industry. The piezoelectric effect has been widely adopted for converting mechanical energy into electricity, due to its high energy conversion efficiency, ease of operation, and miniaturization.

From applications viewpoint, an energy harvesting device has to be able to generate sufficient power under variable excitation. Therefore, academia and industry had concentrated their efforts on methodologies leading to high power output and broad operational bandwidth. Different designs, nonlinear methods, optimization techniques, and harvesting materials have been investigated.

Piezoelectric materials commonly used in energy harvesters include aluminum nitride (AIN), ZnO, $BaTiO_3$, polyvinylidene fluoride (PVDF), PZT, PMN-PT $(Pb[Mg_{1/3}Nb_{2/3}]O_3\text{-}PbTiO_3)$, PZN-PT $(Pb[Zn_{1/3}Nb_{2/3}]O_3\text{-}PbTiO_3)$, and various piezoelectric composites. AIN and ZnO have a much weaker piezoelectric effect than the other commonly used materials. Usually piezoelectric coefficients are order so that $d_{15} \gg d_{33} > d_{31}$. For PZT, $d_{31} \sim 0.5d_{33}$. The single crystals PMN-PT and PZN-PT demonstrate the highest piezoelectric properties, but are more sensitive to temperate change, more susceptible to fatigue, and more difficult to manufacture than lead zirconate titanate ceramics (PZT). Therefore, PZT is still the most popular piezoelectric material in energy harvesters.

However, obtaining a large scale of global deployment for loT (Internet of things) applications requires to consider the piezoelectric material abundance, recyclability and toxicity (RoHS compliance, REACH regulation). Therefore, PZT has to be replaced by lead-free materials. This is typically a necessity when the resulting piezoelectric device has to be used in health device which are implanted in patients, used for general public or used outdoor.

For achieving this objective of industrially producing lead free piezo electric devices, other piezoelectric materials have to be considered.

Lithium niobate ($LiNbO_3$) and lithium tantalate ($LiTaO_3$) crystals are industrially produced piezoelectric materials easily accessible, rare-earth and toxic-element-free, cheap, available in form of wafers (with diameter up to 6 inches (15.24 cm)), widely exploited for developments of acoustics and optical devices.

In particular, $LiNbO_3$ and $LiTaO_3$ present dielectric constants much lower than lead-based piezoelectric materials. In the case of energy applications, this impacts the electromechanical coupling under bending defined as:

$$k_{31} = \frac{d_{31}}{\sqrt{s_{11}^E \varepsilon_{33}^T}} \qquad (1)$$

Piezoelectric energy harvesting demonstration was investigated so far by using industrially available $LiNbO_3$ wafers with thickness of 300 to 1000 $\mu$m. However, they cannot be used in real applications due to unmatched impedance with electronic circuit and their fragility. Examples of prior art may be found in patent documents JPH-11 136964 and US2019/190404 which disclose a piezoelectric device for energy harvesting, wherein a thickness of a piezoelectric film is adapted according to a target output power to be delivered. A further example is found in G. Clementi et. al. "LiNbO3 films - A low-cost alternative lead-free piezoelectric material for vibrational energy harvesters", Mechanical Systems and Signal Processing, vol. 149 (2021) 107171.

There's thus a need for providing a technique for producing energy harvesting piezoelectric devices which can be industrially produced while respecting environmental constraints and while delivering predicable and constant impedance in operational conditions.

### 3. Summary

According to the present disclosure, a flexible piezoelectric device for energy harvesting is proposed. The flexible piezoelectric device comprises a flexible substrate layer of thickness $t_s$ which comprises an upper face and a lower face, and at least one $LiNbO_3$ and/or $LiTaO_3$ film, called LNT film bonded to one of the faces of the flexible substrate layer, wherein thickness $t_f$ of said at least one LNT film is chosen between a use range of 5 to 50 micrometers ($\mu$m).

Thus, the device according to the disclosure allows harvesting energy in an efficient way while respecting both constraints of flexibility, durability and toxicity.

According to the present invention, the thickness $t_f$, of said at least one LNT film, which is comprised between 5 to 50 $\mu$m, is adapted according to a target output power to be delivered by said flexible piezoelectric device during use.

Thus, the device according to the invention is interfaceable with various microelectronic devices so as to deliver a regular power adapted for consumption of such microelectronic devices. According to a particular feature, said flexible substrate layer is made of a metallic material.

Thus, this allows obtaining a thin, while resistant layer, adapted for operational and industrial use.

According to a particular feature, said flexible substrate comprises at least one of nickel (Ni), copper (Cu), iron (Fe), aluminum (Al), titanium (Ti), as well as alloys and combinations thereof, such as brass, stainless steel, Ta6V...

Thus, this allows manufacturing the device in a cheap and reliable process.

According to a particular feature, geometry of said flexible piezoelectric device is adapted according to a target output power to deliver by said flexible piezoelectric device during use.

According to a particular feature, the total thickness ($t_s$,+$t_f$+electrode thicknesses,...) of said flexible piezoelectric device is adapted so as to achieve a predetermined magnitude of deflection of said flexible piezoelectric device according to a target resonance frequency.

According to a particular feature, the film thickness $t_f$ of said flexible piezoelectric device is adapted so as to achieve a predetermined capacitance of said flexible piezoelectric device according to a target resonance frequency.

Hence, the device is able to deliver power as a function of a predetermined application.

According to a particular feature, film thickness $t_f$ of said LNT film and substrate thickness $t_s$ of said flexible substrate layer are selected so as to optimize the effective electromechanical coupling $k^2$ of said flexible piezoelectric device, as a function of thickness ratio ($\frac{t_s}{t_f}$).

Thus, the properties of the LNT materials are optimized as a function of the film thickness, $t_f$.

According to a particular feature, the film thickness, $t_f$, of said LNT film is selected so as to extend deflexional limit of said LNT film during use.

Thus, this allows increasing durability of the device.

According to a particular feature, orientation of piezoelectric tensor of crystals of $LiNbO_3$ and/or $LiTaO_3$ forming said LNT film is chosen so as to optimized the deflexional coupling factor value $k_{23}$ of said LNT film.

Thus, this makes it possible to take maximum advantage of the LNT material properties.

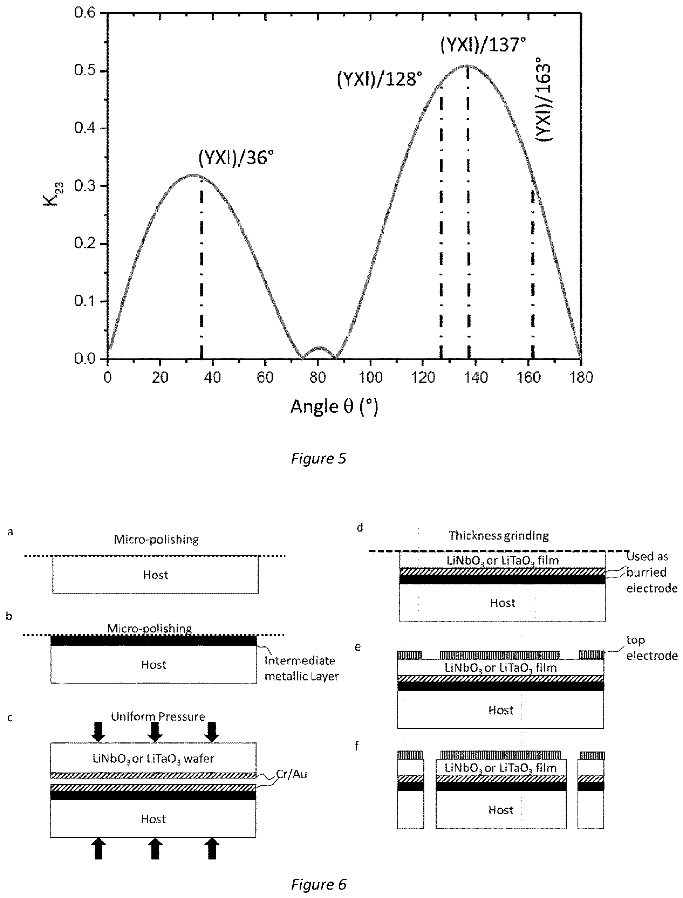

According to a particular feature, orientation of piezoelectric tensor defined the material coupling coefficient (equation 1). Among commercial wafers of $LiNbO_3$ and $LiTaO_3$, the standard cuts correspond to crystal orientated by a rotation angle, around X-axis (also wrote (YXl)/$\theta$ cuts defined by IEEE standard where, $\theta$ is the angle of rotation around X-axis). In these crystals, the better coupling is found for bending in the plane perpendicular to X-axis. Then, according to figure 5, the crystals are chosen into the group of $LiNbO_3$ and $LiTaO_3$ wafers:

- approximatively 36° equivalent to (YXl)/36°;

- approximatively 128° equivalent to (YXl)/128°;
- approximatively 137° equivalent to (YXl)/137°;
- approximatively 163° equivalent to (YXl)/163°.

According to a particular feature, width of the device is about 10 mm, length is comprised between 40 mm and 100 mm and resonance frequency is comprised between 10 Hz and 200 Hz.

According to another aspect, the present invention also provides a method of manufacturing the piezoelectric device as described above. The method of manufacturing comprises:

- preparing a LNT substrate;
- a step of cleaning a host substrate;
- first lapping and polishing steps of the host substrate at least on a single of the two faces of the host substrate;
- a step of depositing a thin intermediate metal film on one face;
- a step of polishing of said deposited metal film;
- a gluing step for transferring the prepared LNT substrate on said host substrate delivering a glued substrate.

According to a specific feature, the step of preparing the LNT substrate comprises:

- a step of depositing an adhesive metallic layer and a gold layer on one side of a piezoelectric single crystal wafer;
  and, after said gluing step:
- a step of preparing at least one cantilever on the basis of said glued substrate;
- a step of thinning said LNT substrate of said at least one cantilever to a target film thickness, $t_f$.

According to another aspect, the disclosure is also directed to a method of manufacturing the piezoelectric device as described above, further comprising the following steps:

- Obtaining a LNT substrate wafer;
- Metal designing by electro-deposition on said wafer;

- preparing at least one cantilever on the basis of said glued metal substrate;
- thinning said LNT substrate of said at least one cantilever to a target film thickness, $t_f$;

## 4. Figures

Embodiments of the present invention can be better understood with reference to the following description and drawings, given by way of example and not limiting the scope of protection, and in which:

- Figure 1 illustrates Power output in terms of the

coupling k$^2$ for the normalized frequency

$$\Omega = \frac{\omega}{\omega_0};$$

- Figure 2 illustrates the deflection of clamped-free beam, under a force F;
- Figure 3 illustrates capacitor schematics; the thickness of the electrodes is not to scale;
- Figure 4 is a diagram disclosing optimization of the capacitance by size effect;
- Figure 5 is a diagram disclosing electromechanical coupling study for LiNbO$_3$ single crystal cut as a function of crystal orientation (YXI)/$\psi$ and a bending in the plane perpendicular to X-axis.
- Figure 6 is a flowchart illustrating a first embodiment of a process for LiNbO$_3$ or LiTaO$_3$ on metal substrate microfabrication steps;
- Figure 7 is a flowchart illustrating a second embodiment of a process for LiNbO$_3$ or LiTaO$_3$ transfer to host material with a sacrificial microfabrication steps;
- Figure 8 is a flowchart illustrating a third embodiment of a process for metal electro-deposition on LiNbO$_3$ or LiTaO$_3$ microfabrication steps.

5. Description

5.1 Description of an embodiment

The present invention relates to a piezoelectric device comprising at least one bonded LiNbO$_3$ and LiTaO$_3$ flexible single crystalline films (LNT Films) of a predetermined film thickness, $t_f$. The present invention also relates to a method for manufacturing said piezoelectric device. Three processes are disclosed. As previously exposed, commonly used piezoelectric materials in energy harvesting are usually not compliant with environmental constraints. The inventors investigated the use of a lithium niobate (LiNbO$_3$) and lithium tantalate (LiTaO$_3$) crystals which present similar efficiency in energy harvesting as commonly used PbZr$_{1-x}$Ti$_x$O$_3$ (PZT). While promising, the use of these materials raised several problems that the inventors successively solved so has to obtain an industrially makeable device. For example, to respond to a problem of flexibility and brittleness of silicon wafer, the inventors had to develop some strategies to use metallic and polymer substrates. These strategies had conducted to implement several methods of manufacturing and integration of LiNbO$_3$ and LiTaO$_3$ flexible single crystalline films.

More generally, the inventors also determined the importance of optimizing the effects of crystal orientation, film thickness, $t_f$, flexibility and capacitance, which are all considerations necessary for energy harvesting applications. LiNbO$_3$ and LiTaO$_3$ flexible single crystalline films (LNT Films) have high sensitivity and interest in several applications such as sensors, micro-devices (called MEMS), Micro and Macro devices for energy harvesting, actuators, and more generally a component of a device using piezoelectric or pyroelectric robust and flexible films such as IoTs, autonomous wireless sensors, flexible devices, wearable devices, high-temperature devices/local power supply, etc. This necessitate however, according to the invention, to configure the parameters of the LNT films which are used in order to obtain piezoelectric devices which are similar, in terms of performances, to the ones manufactured with commonly used PZT.

Thus, it is proposed, in a general approach, to use widely commercially available and high-quality single crystal lead-free piezoelectric materials (LiNbO$_3$ and LiTaO$_3$), with special care on optimization of film thickness, $t_f$, capacitance and orientation. The disclosure comprises five optimizations (combinable) for the production of flexible single piezoelectric materials:

- The optimization of flexible single crystal LiNbO$_3$ (or LiTaO$_3$) by size effect;
- Electrode design and optimization of capacitance by size effect;
- The optimization of piezoelectric coefficients by rotation of LiNbO$_3$ (or LiTaO$_3$) single crystals;
- A viable method to transfer the piezoelectric thick film on any flat host-substrate;
- The production of LiNbO$_3$ (or LiTaO$_3$) single crystal on flexible substrate.
- There is also that there is no need for poling the ferroelectric domains.
- The temperature range of use is superior to PZT due to the Curie temperature

The invention hence proposes a suitable microfabrication process and the application to vibrational energy harvesters based on film thickness, $t_f$, (5 to 50 μm) of single-crystal LiNbO$_3$ and LiTaO$_3$ films bonded on flexible substrate. Indeed, according to the invention, as a function of the application, the thickness $t_f$ of the LNT film (or films) is adapted. More specifically, given several optimizations (disclosed herein after, electromechanical coupling, size, etc.), total thickness t of the piezoelectric device is also optimized so as to provide the desired power output (in calculation thickness of electrode $t_{electrode}$ is considered as negligible). Once determined an output power needed for the device, and once determined an orientation of the piezoelectric tensor around x-axis by $\psi$ angle (which allows a first optimization of the piezoelectric electromechanical coupling of the material $k_{ij}^2$ ), several optimizations are implemented, mainly based film thickness $t_f$ of the LNT film (or films) and on size of the device (length, width).

More specifically, the harvester is deemed to be capable of generating a voltage, V, that can be converted into electrical power whenever connected to a load. If the excitation of the beam is sinusoidal, the voltage response is AC (alternative current), therefore one has to consider the root mean squared (RMS) value of *V*. In consequence, the power dissipated in the resistive load, $R_l$, is given as:

$$P_{RMS} = \frac{V_{RMS}{}^2}{R_l}.$$

If one examines the instantaneous power response for a piezoelectric generator in impedance matching condition, one has:

$$P_{RMS} = \frac{\omega}{4} \, k_{ij}^2 \, c_{jj}^E \, (St_f) \, X_j^2 \qquad (1)$$

where $\omega$ is driving angular velocity, $k_{ij}^2$ is the electromechanical coupling of the material, $c_{jj}^E$ the piezoelectric stiffness at constant electric field, S is the active surface, $t_f$ and $X_i$ are film thickness of the piezoelectric layer and mechanical strain respectively.

From equation 1, the inventors identified the parameters to optimize:

- with regards to the frequency, one should work at the maximum frequency available from the system, hence tune the cantilever response to the resonance of the system $\omega$.
- with an optimized orientation of LiNbO$_3$ and/or LiTaO$_3$, one can improve the piezoelectric electromechanical coupling of the material $k_{ij}^2$.
- the active area $S$ and film thickness $t_f$ of the piezoelectric layer are more critical. Even if they are proportional to the power delivered, they must be designed in order to have good impedance matching with the electronic interface, thus the capacitance has to be in the order of *nF* range.
- one could exploit higher tip displacement magnitude to increase the strain level of the piezoelectric material.

finally, one could improve the electronic interface and the energy extraction cycles for the device.

For example, in order to implement the material on a hosting substrate of subtsrate thickness $t_s$ and with a given stiffness, one has to choose correctly the film thickness $t_f$ of the piezoelectric material. As exposed above, one parameter to consider is the effective electromechanical coupling $k^2$, which is the ratio between the converted energy and total input energy.

The inventors determined how $k^2$ depends on the thickness ratio ( $\frac{t_s}{tf}$ ), and ruled that is possible to investigate its maximum value as a function of this thickness ratio. For example, using the LiNbO$_3$ orientation (YXl)/128°, the inventors ruled that the optimized thickness ratio condition to be in the rage of 2.3, which correspond to a 30 $\mu$m piezoelectric film thickness, $t_f$. For this range of piezoelectric film thickness, $t_f$, the inventors determined that a change the length of the beam, do not imply considerable variation in terms of k$^2$. Moreover, the inventors determined that it is possible to further increase the value of $k^2$ using different substrate thicknesses and stiffness of the substrate. The capacitance for such device is about 4 nF, for an active surface area of 270 mm$^2$.

With regards to the frequency of the beam, the inventors ruled that it is possible to lower its response and increase the displacement considering different thickness of the substrate. The bending resonance is thus tuned in terms of the ratio ( $\frac{t_s}{t_f}$ ). Therefore, if one reduces the substrate thickness, it is possible to attain lower frequency response. Other possibilities are to change the length of the beam once the optimized total thickness of the cantilever is found or to add a mass tip to the unclamp side of the beam. For instance, considering a beam width of 10 mm, and varying the beam length from 20 mm to 100 mm, one can tune the frequency from 200 Hz down to 10 Hz. The width of the beam can be as low as 5 mm.

Thus, as example, for a cantilever with these features, one can estimate the power response while varying the length of the piezoelectric device. The inventors ruled that the maximum instantaneous power took at resonance increases with the length of the cantilever, ranging from 1 $\mu$W up to 400 $\mu$W. In fact, the available energy increases with the volume of piezoelectric material under strain and for longer beams one can attain higher displacement. Eventually, metal substrates like stainless steel have high quality factor and reliability, and they can be exploited to increase the power output of the harvesters.

Usually, the voltage delivered to a sensor, by a piezoelectric device of the type described above, he has to be in DC, whereas the most common electronic configuration to convert AC to DC signals is a standard full-bridge rectification circuit. This electronic interface consists in 4 diodes and a smoothing capacitor, $C_r$, able to store the rectified voltage, $V_{DC}$. Considering standard dimensions for the beam (e.g. 60 mm by 10 mm), the inventors ruled the rectified power in terms of the coupling k$^2$. One defines the normalized frequency $\Omega = \frac{\omega}{\omega_0}$, where $\omega_0$ is the resonance frequency of the beam, thus the optimal power in function of k$^2$ is given as:

$$P_{opt} = \frac{F^2}{\omega_0 M} \frac{1}{2\pi} \frac{k^2 \Omega}{\left(2\zeta\Omega + \frac{k^2}{\pi}\right)^2} \qquad (2)$$

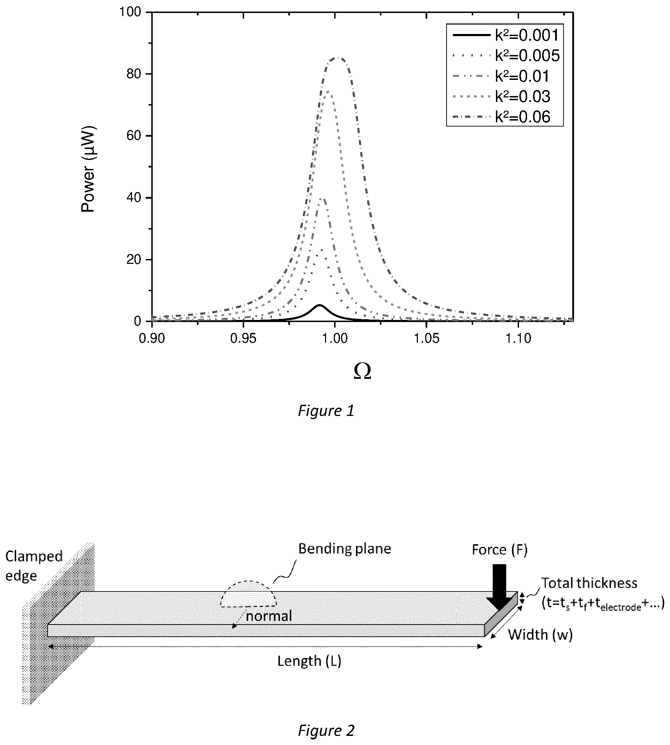

Where *F* is the excitation force, M the mass of the harvester and $\zeta$ the mechanical damping of the structure. In order to operate a small sensor, one assumes that the power delivered to the load has to be above 20 $\mu$W. Hence, one can estimate the power output of the harvester considering a reasonable structural damping ($\zeta$ = 0.01) and an excitation force driven by an acceleration of 2 m/s$^2$. In Fig. 1 is presented the optimal power output in such conditions. The harvester starts to generate enough power already with a coupling of 0.005 while it reaches the maximum at 0.06. If k$^2$ is increased over this value, there will be no improvement of the power, because the structural damping is limiting the harvester output, and only the frequency bandwidth will increase.

The optimizations on film thickness, $t_f$, of the piezoelectric material and of the substrate thus have consequence both on the coupling factor and on the power delivered by the device. These optimizations are presented herein after. In consequence, the piezoelectric device produced with one or several of the optimizations, has the following advantages:

- The use of high quality piezoelectric single crystal materials, LiNbO$_3$ and LiTaO$_3$, present many advantages in terms of properties and processing:

    - They are extremely chemically inert that can be used in harsh environmental conditions in particular at high temperature and in corrosive/reducing environment;
    - They are lead-free material, which follow Eu regulation (RoHS, Reach) and can be lost with minimal impact to the environment
    - The use of very high Curie temperature (LiNbO$_3$ > 1150 °C, LiTaO$_3$ > 600 °C) make it compatible with process (for instance vulcanization) at high temperatures without re-poling as well as high-temperature applications (sensors, local micro-power supply).
    - Industrially available and high-quality wafers (up to 6 inches (15.24 cm) in diameter), with reliable piezoelectric and pyroelectric properties.

- The use of metal foils as substrate, is granting better performances and reliability. While silicon substrates present higher resonance frequencies and brittleness, metal substrates (such as brass or stainless steel) present flexibility, low cost and robustness. Eventually, prototypes with metal substrate, because of superior mechanical performance, have longer lifetime and reliability.

Once the piezoelectric element and the metal substrate, are bonded together, the harvester can withstand higher acceleration levels and target application with lower resonance frequencies *(from 10 to 500 Hz)*. In addition, even if the dielectric constant of the piezoelectric materials is low, it is possible to reduce the film thickness locally to achieve reasonable capacitance (nF scale). In this way, one can develop prototypes attaining realistic impedance-matching conditions between the piezoelectric transducer and the electronic interface.

5.2 <u>Disclosure of features of piezoelectric device's features and optimizations</u>

5.2.1. *optimization of a flexible flat stack structures: including the consideration of the flexibility, the stresses loads and the resonant frequency of single crystal LNT film by size effect, shape and composite host materials*

According to the disclosure, in one embodiment, the inventors demonstrated that optimization of flexible single crystal LNT film depends on size effect. Considering, a simple LNT film beam, the decrease of the film thickness, $t_f$, increases the deflection. In the frame of a simple beam with uniform rectangular section, the result can be at first order described by the equation of isotropic beams deflection in the frame of originates Euler-Bernoulli formalism but can be extended to more complex modelling (Figure 2).

In a simplistic way, one can define the deflection d, in function of a force F and length L, with Young's modulus E as:

$$d = \frac{1}{48}\frac{L^3 F}{IE} \tag{3}$$

With an inertia moment defined as $I = \frac{1}{12}w t_f{}^3$, where w is the width and $t_f$ the film thickness of the piezoelectric device respectively. From this equation one can see that the deflection is proportional to $\frac{1}{t_f{}^3}$, so that the film thickness has a strong effect on the magnitude of deflection. This equation is valid with linear materials that are isotropic, but if one considers anisotropic properties of LiNbO$_3$ (or LiTaO$_3$), the inventors state that it can be also modeled with finite element simulations to reach the optimized thickness, $t_f$. By extension to the exposed beam theory, the addition of the substrate material of thickness, $t_s$, the electrodes, the shape of the structure that can be supported by 1, 2 or more distributed points (i.e. not limited to a beam) can be modeled with finite element simulations to reach optimized parameters whose the total thickness $t = t_s + t_f$, of the composite device.

Optimization of resonance frequency can also be achieved with optimization dimension of dimension of the piezoelectric device. The vibration of a simple - one-end clamped structure can be solved using continuous mechanic of beams. A simplified expression gives for the first vibration mode a resonant frequency $f_1$ :

$$f_1 = \frac{(1.875)^2}{2\pi} \sqrt{\frac{EI}{\rho A L^4}} \qquad (4)$$

Where $\rho$ is the density and A= $wt$ the area of the section. The product $\rho$A is the mass per unit length supposed uniform. Others parameters where defined in equation (3).

Considering a composite structure made of a host substrate, or more than one, the deflection depends on the inertial moment of the composite structure. It includes one, two (bimorph) or more multiple piezoelectric elements (stack), or fiber those the ferroelectric polarization can be controlled to more efficiency. For instance, in the case of bimorph, the structure is composed by two active piezoelectric layers, and one central passive layer that represents the host. The piezoelectric elements can be connected either in parallel or series connection. Given two identical piezoelectric elements, in the first case, since the two capacitors are in parallel, the equivalent capacitance is doubled and so is the current. The series connection instead reduces the capacitance but increases the voltage. Both the connections can be implemented taking into account the polarization of the piezoelectric layers. Multi-morph structures instead, are usually implemented with several piezoelectric and passive layers in between, and are mostly used for actuation purposes.

The range of deflection is limited by the fracture's mechanisms of the composite. In particular LNT wafers are brittle under loadings. To ensure high flexibility and viable structure with LNT films, one condition is to reduce the thickness $t_f$ of the film.

In order to prevent tensile stresses, pre-constrained piezoelectric film can be undertaken under compressive stresses, inventors have found that method known in the art can be applied.

Another way is to transfer the film on others flexible host substrates composite so that the stresses is always low or in compression in the LNT film. The engineer calculation, will determine the position of the neutral axis in function of the applied loads and in function of parameters such as the shape geometry, the thicknesses, $t_s$ and $t_f$ and widths of the beams, the number of the composite beams, the elastic modulus of the LNT film and of the host flexible substrates.

For instance, if one will reduce the stress in the LNT film, and, considering a simple two-composite beam with a single host substrate having a Young modulus, E, higher than LNT (n=$E_{host}$/$E_{LNT}$>1, for instance stainless steel). Our calculation under bending load, gives a stress in LNT film reduced by 1/n for a host substrate have a thickness, $t_s$, lower than the one of LNT film $t_f$. More complex beam with multiple piezoelectric LNT films and flexible hosts of different material can ensure better viability and lifetime.

The piezoelectric harvesting system can include all possible shapes described in literature such as: MEMS devices, cantilever, spiral, multi-resonant structures, bimorph and stack structure with polarity inversion or periodically poled structures. These specific shapes can be obtained by different techniques: saw cutting, ions beams cutting, etching with acid solution, reactive ion etching (DRIE), laser cutting and electrical poling or a combination of these techniques.

*5.2.1. electrode design and optimization of capacitance by size effect*

The host crystal is not necessarily conductive, therefore the thin metallic films used in the transfer will act as an electrode (also called burry electrode). The second electrode of the structure can be deposited on the top of the structure, or, in the case of a stack composite, the second electrode can be buried.

Considering two electrodes on top and bottom of a flat piezoelectric film, and from the general theory of linear dielectric, the capacitance is inversely proportional to the thickness, $t_f$ of the piezoelectric element and proportional to the areas of the electrode,

$$C = \frac{\varepsilon S}{t_f} \qquad (5)$$

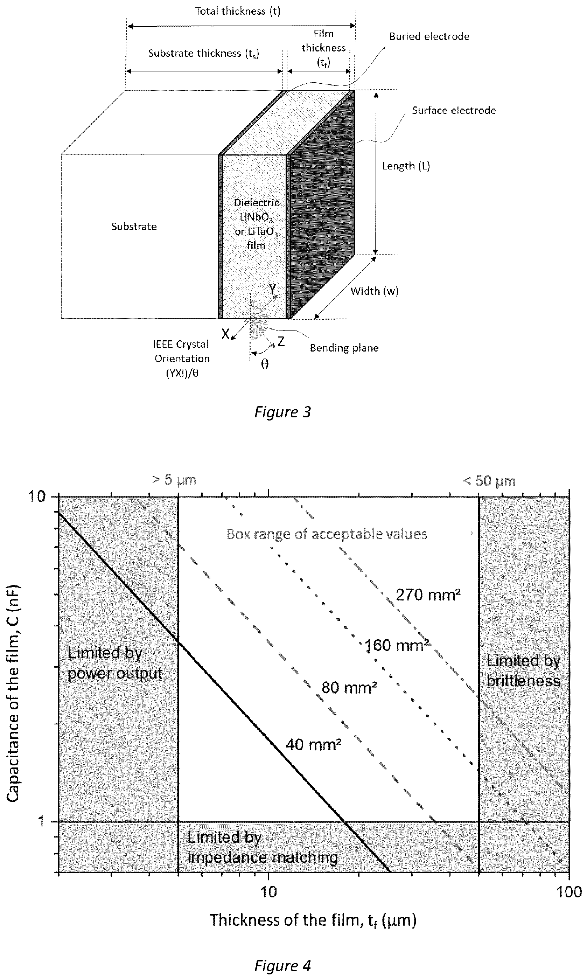

Where $\varepsilon$ is the dielectric permittivity of the piezoelectric material, S the surface of the electrodes and $t_f$ the thickness of the dielectric layer (Figure 3). In order to optimize the capacitance both $t_f$ and $S$ parameters has to be tuned. However, the surface S is constrained by the application. For instance, in macro devices (S > mm$^2$), the surface is not enough to have high capacitance, whereas, for micro devices (S < mm$^2$) the surface is small. Thus, the inventors submit that the thickness is the first parameter to optimize to get a high capacitance, in accordance with the desired application.

For instance, if the goal is to achieve a capacitance superior to 1 nF (nano-farads), to have realistic impedance matching with electronic interface, the thickness $t_f$ would be inferior to 15 $\mu$m, having a surface of approximately 40 mm$^2$ (Figure 4).

In terms of electronic configuration, the internal resistance of the piezoelectric element follows the equation:

$$R_{in} = \frac{1}{2\pi f C} \qquad (6)$$

Where f is one of driving frequencies of the ambient vibration. For an optimized piezoelectric layer, the driving frequencies is the resonant frequency of the structure adapted to the ambient vibrations. The optimized internal resistance is in the $k\Omega$ range, compatible with low power electronics.

*5.2.1. Optimization of piezoelectric coefficients by rotation of* LiNbO$_3$ *(or* LiTaO$_3$*) single crystals*

Commercial wafer of LNT are of hundreds $\mu$m to 1 mm thick poled single crystal and oriented by IEEE convention: (YXI)/$\theta$ LiNbO$_3$ or LiTaO$_3$. The piezoelectric element orientation is important in order to have optimal values for the piezoelectric coefficients. One can choose carefully among the commercially available cuts, to have the desired properties. Figure 5 shows how one can rotate the piezoelectric tensor around x-axis by $\theta$ angle. Here the electromechanical coupling factor related to transverse mode, $k_{23}$, is plotted (the index 2 corresponds to the bending perpendicular to X-axis) and also different oriented cuts for some commercially available LiNbO$_3$ wafers. The graph shows that the best configuration is achievable with LiNbO$_3$ (YXI)/137° orientation, where one has the highest coupling factor value $k_{23}$ = 0.51.

Eventually, (YXI)/128° orientation can be chosen as they are commercially available.

This optimization can be coupled with the two previous ones so as to obtain desired characteristics of the piezoelectric device.

5.3 Processes for manufacturing a piezoelectric device according to the disclosure

The transfer to flat host-substrate or the stack of any composition has to be taken into consideration from the manufacturing origin of the substrate specimen. Here one assumes the transfer to a flat solid materials which can be characterized by a high viscosity (viscosity > 10$^4$ Pa.s) or elastic Young modulus (E > 1 GPa). It includes materials such as:

- Plastic and more generally organic materials of any composition;
- Glass and transparent materials;
- Metal, metal shim laminate or cast metal of any composition;
- Metal as a result of electrodeposition;
- Polycrystalline ceramics or single crystalline of any composition;
- Semiconductors, such as silicon single crystal;
- Artificial and natural composites and reinforced materials.

The first element is flatness (or TTV) and roughness of the host, to allow the gluing process. The inventors state that the preparation of the surface of the substrate has to be made by several step comprising:

- Cleaning with proper organic and inorganic solution with/without ultrasound depending of the host substrate properties;
- First grinding and/or polishing of the host substrate to decrease the TTV at least on a single of the two faces of the substrate;

- Deposition of a thin intermediate metal on one face;
- Re-polishing of deposited film;
- Use one of the described gluing processes to transfer the flexible LiNbO$_3$ or LiTaO$_3$ film as described herein after.

According to the disclosure, the inventors state to use gluing by thermocompression, for instance with Cr/Au-Au/Cr bonding on prepared flat host material, and by extension the method described applies also to molecular gluing. For replacing Cr, other adhesive metals on lithium niobate may by used: aluminum, titanium, copper, ... In practice, since gold does not directly adhere to niobate, one tends to use chromium or another metal as an interface between the two. On the second side (i.e. the second side of the substrate or the thermo-compressed side of the film), one could use another metal combination if needed. More specifically, the inventors propose three possible processes for the production of flexible single crystal of LiNbO$_3$ or LiTaO$_3$ films of thicknesses, $t_f$, below conventional wafers. The proposed processes are simple and reproducible because LiNbO$_3$ / LiTaO$_3$ is a commercial product whose characteristics are stable and inexpensive and the bonding of such LNT films ensure stability and durability of the resulting piezoelectric device.

Unlike PZT, which necessitate a polarization process, during which a strong DC electric field is provided through the electrodes at a temperature a little below the Curie temperature, the proposed technique does not need any polarization. This polarization step is omitted in the disclosed processes because the Curie temperature is >600°C for LiTaO$_3$ and >1150°C for LiNbO$_3$. For avoiding this step, the inventors state it is preferable to use the orientation (see above) to improve the coupling, whereas this one is fixed by the direction of polarization in the case of PZT.

Additionally, unlike in the classic solution which is to attach a piezoelectric element on a flexible beam structure, the proposed processes differ because the complete structure of the device is created on a wafer. It is thus not a system comprising several attached elements, but an integrated system. It has thus to be understood that one realizes the composite structure before shaping, whereas in general the piezo element is added after.

*5.3.1. First process' embodiment*

A first process consists essentially in direct wafer gluing on any host material or composite, and is described according to Figure 6.

i. The host is prepared to decrease the surface roughness and the TTV, by grinding, polishing and/or lapping (Fig. 6, step a).

ii. Afterwards, a thick metal layer (typically 1 $\mu$m, depending on the roughness) is deposited by sputtering on the metal foil and successively micro-polished, in order to have a smoother surface (Fig. 6, step b).

iii. Then, Cr adhesive layer (around 30 nm thick) and Au layers (around 150 nm thick) are deposited on one side of the piezoelectric single crystal wafer and on one side of the polished side of the host (Fig. 6, step b). The LiNbO$_3$ (or LiTaO$_3$) and host substrate are bonded by means of mechanical compression (Fig. 6, step c) of Au layers (EVG wafer bonder). The Cr/Au layer used for wafer bonding is also acting as bottom electrode of the device.

iv. The LiNbO$_3$ (or LiTaO$_3$) wafer face is thinned, here by grinding step (Fig. 6, step d), or locally by ultrasound polishing, RIE or any technique to the target thickness, $t_f$.

v. The top electrode is deposited, here, by lift-off process (Fig. 6, step e).

vi. The cantilevers are prepared in the desired shape, here by dicing saw (Fig. 6, step f) or any other mechanical, laser cutting or ionic abrasion.

vii. The final dimensions and shape of the device is adjusted in order to match the required mechanical and coupling properties (Fig.6, step d, e and f).

### 5.3.2. Second process' embodiment

The LiNbO$_3$ or LiTaO$_3$ wafer is initially prepared on an intermediary or sacrificial crystal that can be prepared in laboratory, directly bought from a company or obtained by smart-cut or ions implanted sliding.

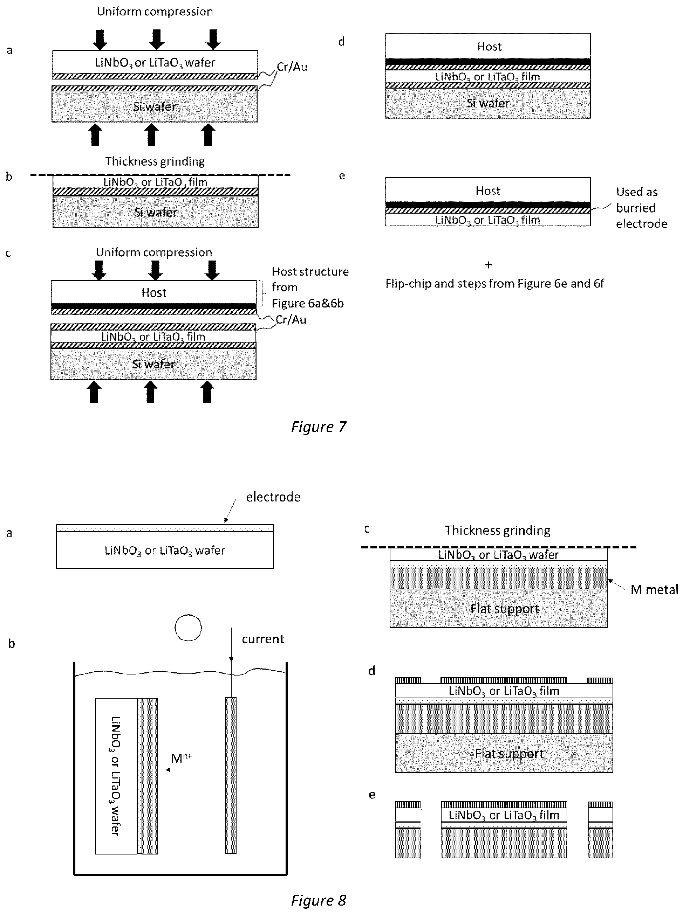

However, the smart-cut process does not allow to attain thick films (with thickness, $t_f > 1 \mu$m) necessary for efficient energy harvesting. For instance, one uses silicon intermediate crystal prepared by Au-Au thermocompression. The process is described according to figure 7.

i. The technique consists in LiNbO$_3$ (or LiTaO$_3$)/Cr/Au-Au/Cr/Si prepared by Au-Au thermocompression (Fig. 7, step a);

ii. Grinding and/or polishing the LiNbO$_3$ or LiTaO$_3$ wafer to the desired thickness, $t_f$ (Fig. 7, step b).

iii. Gluing on final host flexible material or composite by one of the techniques of thermocompression (Fig. 7, step c) to obtain the structure described in Fig. 7d.

iv. Dissolution of Si by an adapted process (here KOH) (Fig. 7, step e).

v. The final dimensions and shape of the device is adjusted in order to match the required mechanical and coupling properties as previously described (Fig.6, steps e and f).

### 5.3.3. Third process' embodiment

The process consists essentially in direct growth of the host structure on LiNbO$_3$ (or LiTaO$_3$) wafer and is described in Figure 8. The process comprises:

i. The initial coating of a thin metallic electrode (here 200 nm of copper by sputtering) on a LiNbO$_3$ (or LiTaO$_3$) wafer (Fig. 8, step a);

ii. A thick metal deposition by electro-deposition to the desire thickness of the substrate, $t_s$ (here 30 $\mu$m of nickel) (Fig. 8, step b);

iii. The sample is flip-chip and glued onto a flat support (here thermal resin on silicon wafer). The piezoelectric element is grinded to the desire thickness, $t_f$ (Fig 8, step c)

iv. The top electrode is carefully patterned by sputtering by stencil technique through a mask (Fig. 8, step d).

v. The samples are the diced to the desired shape and the flat support is remove upon heating.

It is to note that electro-deposition of metallic substrate could be realized onto an initial structure made of LiNbO$_3$ (or LiTaO$_3$)/Cr/Au-Au/Cr/Si prepared by Au-Au thermocompression , Fig. 7, step a), grinded (Fig. 7, step b) and top electrode deposition (Fig. 8, step a). Thick photoresist pattering could then be done prior to the electro-deposition. The method has shown to have the advantage to present lower stresses and wafer bending, but lost the interest to directly bond the metallic substrate onto the piezoelectric element. It is also interesting to note that the electrodeposition can be done simultaneously on both side of the initial LiNbO$_3$ or LiTaO$_3$ wafer by deposition of electrode on both side (Fig 8.a) to compensate the stresses due to electrodeposition. The method necessitates however to change the grinding wheel to remove the metal and then to decrease the piezoelectric element.

### Claims

1. Flexible piezoelectric device for energy harvesting comprising a flexible substrate layer which comprises an upper face and a lower face, and at least one LiNbO$_3$ and/or LiTaO$_3$ film, called LNT film, bonded to one of the faces of the flexible substrate layer,
   **characterised in that a** thickness $t_f$ of said at least one LNT film is chosen within a range of 5 to 50 micrometers and is adapted according to a target output power to be delivered by said flexible device during use.

2. Flexible piezoelectric device according to claim 1, **characterized in that** said flexible substrate layer is made of a metallic material.

**3.** Flexible piezoelectric device according to claim 2, **characterized in that** said flexible substrate comprises at least one of nickel (Ni), copper (Cu), iron (Fe), aluminium (Al), titanium (Ti), as well as alloys and combinations thereof.

**4.** Flexible piezoelectric device according to claim 1, **characterized in that** a geometry of said flexible piezoelectric device is selected according to a target output power to be delivered by said flexible piezoelectric device during use.

**5.** Flexible piezoelectric device according to claim 1, **characterized in that** the total thickness $t = t_s + t_f$ of said flexible piezoelectric device is selected so as to achieve a predetermined magnitude of deflection of said flexible piezoelectric device, where $t_f$ is the film thickness and $t_s$ is the substrate thickness, according to a target resonance frequency.

**6.** Flexible piezoelectric device according to claim 1, **characterized in that** the film thickness, $t_f$, of said flexible piezoelectric device is selected so as to achieve a predetermined capacitance of said flexible piezoelectric device according to a target resonance frequency.

**7.** Flexible piezoelectric device for energy harvesting according to claim 1, **characterized in that** the thickness $t_f$ of said LNT film and a thickness $t_s$ of said flexible substrate layer are selected so as to optimize the effective electromechanical coupling $k^2$ of said flexible piezoelectric device, as a function of thickness ratio ( $\dfrac{t_s}{t_f}$ ).

**8.** Flexible piezoelectric device for energy harvesting according to claim 1, **characterized in that** the film thickness, $t_f$, of said LNT film is selected so as to extend a deflexional limit of said LNT film during use.

**9.** Flexible piezoelectric device for energy harvesting according to claim 1, **characterized in that** an orientation of crystals of $LiNbO_3$ and/or $LiTaO_3$ forming said LNT film is chosen so as to optimize the deflexional coupling factor value $k_{23}$ of said LNT film.

**10.** Flexible piezoelectric device for energy harvesting according to claim 4, wherein an orientation of the piezoelectric tensor around X-axis is defined by $\theta$ angle according to IEEE standard, the bending occurring in the plane perpendicular to X-axis, and the $\theta$ angle value belonging to the group consisting of:

- approximatively 36° equivalent to (YXl)/36°;
- approximatively 128° equivalent to (YXl)/128°;
- approximatively 137° equivalent to (YXl)/137°;
- approximatively 163° equivalent to (YXl)/163°.

**11.** Flexible piezoelectric device for energy harvesting according to claim 1, **characterized in that** a width of the device is about 10 mm, a length is comprised between 40 mm and 100 mm and a resonance frequency is comprised between 10 Hz and 200 Hz.

**12.** A method of manufacturing a piezoelectric device according to any of claims 1 to 11, comprising:

- preparing a LNT substrate;
- a step of cleaning a host substrate;
- first lapping and polishing steps of the host substrate at least on a single of the two faces of the host substrate;
- a step of depositing a thin intermediate metal film on one face;
- a step of polishing said deposited metal film;
- a gluing step for transferring the prepared LNT substrate on said host substrate delivering a glued substrate.

**13.** Method of manufacturing a piezoelectric device according to claim 12 where the step of preparing the LNT substrate comprises:

- a step of depositing an adhesive metallic layer and a gold layer on one side of a piezoelectric single crystal wafer;
and, after said gluing step:
- a step of preparing at least one cantilever on the basis of said glued substrate;
- a step of thinning said LNT substrate of said at least one cantilever to a target thickness, $t_f$.

**14.** Method of manufacturing a piezoelectric device according to claim 12, further comprising:

- obtaining a LNT substrate wafer;
- metal electro-deposition on said wafer;
- thinning said wafer to a target thickness, $t_f$.

**Patentansprüche**

**1.** Flexible piezoelektrische Vorrichtung zur Energiegewinnung umfassend eine flexible Substratschicht, die eine Oberseite und eine Unterseite, und mindestens einen $LiNbO_3$- und/oder $LiTaO_3$-Film, genannt LNT-Film, umfasst, welcher auf eine der Seiten der flexiblen Substratschicht geklebt ist, **dadurch gekennzeichnet, dass** eine Dicke $t_f$ des mindestens einen LNT-Films in einem Bereich von 5 bis 50 Mikrometern gewählt ist und entsprechend einer Ziel-Ausgangsleistung angepasst ist, die von der flexiblen Vorrichtung während der Verwendung abgegeben werden soll.

**2.** Flexible piezoelektrische Vorrichtung nach Anspruch 1, **dadurch gekennzeichnet, dass** die flexible Substratschicht aus einem metallischen Material besteht.

**3.** Flexible piezoelektrische Vorrichtung nach Anspruch 2, **dadurch gekennzeichnet, dass** das flexible Substrat mindestens eines von Nickel (Ni), Kupfer (Cu), Eisen (Fe), Aluminium (Al), Titan (Ti), sowie Legierungen und Kombinationen davon umfasst.

**4.** Flexible piezoelektrische Vorrichtung nach Anspruch 1, **dadurch gekennzeichnet, dass** eine Geometrie der flexiblen piezoelektrischen Vorrichtung in Abhängigkeit von einer Ziel-Ausgangsleistung ausgewählt ist, die von der flexiblen piezoelektrischen Vorrichtung während der Verwendung abgegeben werden soll.

**5.** Flexible piezoelektrische Vorrichtung nach Anspruch 1, **dadurch gekennzeichnet, dass** die Gesamtdicke
$t=t_s+t_f$
der flexiblen piezoelektrischen Vorrichtung so gewählt wird, dass eine vorbestimmte Größe der Auslenkung der flexiblen piezoelektrischen Vorrichtung erreicht wird, wobei $t_f$ die Filmdicke und $t_s$ die Substratdicke ist, entsprechend einer Zielresonanzfrequenz.

**6.** Flexible piezoelektrische Vorrichtung nach Anspruch 1, **dadurch gekennzeichnet, dass** die Filmdicke $t_f$ der flexiblen piezoelektrischen Vorrichtung so gewählt ist, dass eine vorbestimmte Kapazität der flexiblen piezoelektrischen Vorrichtung entsprechend einer Zielresonanzfrequenz erreicht wird.

**7.** Flexible piezoelektrische Vorrichtung zur Energiegewinnung nach Anspruch 1, **dadurch gekennzeichnet, dass** die Dicke $t_f$ des LNT-Films und eine Dicke $t_s$ der flexiblen Substratschicht so gewählt werden, dass die effektive elektromechanische Kopplung $k^2$ der flexiblen piezoelektrischen Vorrichtung in Abhängigkeit des Dickenverhältnisses ($\frac{t_s}{t_f}$) optimiert wird.

**8.** Flexible piezoelektrische Vorrichtung zur Energiegewinnung nach Anspruch 1, **dadurch gekennzeichnet, dass** die Filmdicke $t_f$ des LNT-Films so gewählt ist, dass eine Auslenkungsgrenze des LNT-Films während der Verwendung verlängert wird.

**9.** Flexible piezoelektrische Vorrichtung zur Energiegewinnung nach Anspruch 1, **dadurch gekennzeichnet, dass** eine Orientierung der Kristalle von LiNbO$_3$ und/oder LiTaO$_3$, die den LNT-Film bilden, so gewählt ist, dass der Wert des Auslenkungs-Kopplungsfaktors $k_{23}$ des LNT-Films optimiert wird.

**10.** Flexible piezoelektrische Vorrichtung zur Energiegewinnung nach Anspruch 4, wobei eine Orientierung des piezoelektrischen Tensors um die X-Achse durch den Winkel θ gemäß IEEE-Standard definiert ist, die Biegung in der Ebene senkrecht zur X-Achse erfolgt und der θ-Winkelwert zur Gruppe gehört, die besteht aus:

- etwa 36° entsprechend(YXl)/36°;
- etwa 128° entsprechend (YXl)/128°;
- etwa 137° entsprechend (YXl)/137°;
- etwa 163° entsprechend (YXl)/163°.

**11.** Flexible piezoelektrische Vorrichtung zur Energiegewinnung nach Anspruch 1, **dadurch gekennzeichnet, dass** eine Breite der Vorrichtung etwa 10 mm beträgt, eine Länge zwischen 40 mm und 100 mm umfasst und eine Resonanzfrequenz zwischen 10 Hz und 200 Hz umfasst.

**12.** Verfahren zur Herstellung einer piezoelektrischen Vorrichtung nach einem der Ansprüche 1-11, umfassend:

- Vorbereiten eines LNT-Substrats;
- einen Schritt zum Reinigen eines Wirtssubstrats;
- erste Läpp- und Polierschritte des Wirtssubstrats auf mindestens einer der beiden Flächen des Wirtssubstrats;
- einen Schritt zum Aufbringen einer dünnen Metallzwischenschicht auf einer Seite;
- einen Schritt zum Polieren des aufgebrachten Metallfilms;
- einen Klebeschritt zum Übertragen des vorbereiteten LNT-Substrats auf das Wirtssubstrat, wodurch ein geklebtes Substrat entsteht.

**13.** Verfahren zur Herstellung einer piezoelektrischen Vorrichtung nach Anspruch 12, wobei der Schritt der Vorbereitung des LNT-Substrats umfasst:

- einen Schritt zum Aufbringen einer metallischen Haftschicht und einer Goldschicht auf einer Seite eines piezoelektrischen Einkristallwafers;
und nach diesem Klebeschritt:
- einen Schritt zum Vorbereiten mindestens eines Auslegers auf der Grundlage des geklebten Substrats;
- einen Schritt zum Ausdünnen des LNT-Substrats des mindestens einen Auslegers auf eine Zieldicke $t_f$.

**14.** Verfahren zur Herstellung einer piezoelektrischen Vorrichtung nach Anspruch 12, ferner umfassend:

- Erhalten eines LNT-Substrat-Wafers;
- Metall-Elektroabscheiden auf dem Wafer;
- Ausdünnen des Wafers auf eine Zieldicke $t_f$.

**Revendications**

**1.** Dispositif piézoélectrique flexible pour la récupération d'énergie comprenant

une couche de substrat flexible qui comprend une face supérieure et une face inférieure, et au moins un film de LiNbO$_3$ et/ou de LiTaO$_3$, appelé film de LNT, collé à l'une des faces de la couche de substrat flexible,
**caractérisé en ce qu'**une épaisseur $t_f$ dudit au moins un film de LNT est choisie dans une plage de 5 à 50 micromètres et est adaptée selon une puissance de sortie cible devant être délivrée par ledit dispositif flexible pendant l'utilisation.

**2.** Dispositif piézoélectrique flexible selon la revendication 1, **caractérisé en ce que** ladite couche de substrat flexible est composée d'un matériau métallique.

**3.** Dispositif piézoélectrique flexible selon la revendication 2, **caractérisé en ce que** ledit substrat flexible comprend au moins l'un parmi le nickel (Ni), le cuivre (Cu), le fer (Fe), l'aluminium (Al), le titane (Ti), ainsi que des alliages et leurs combinaisons.

**4.** Dispositif piézoélectrique flexible selon la revendication 1, **caractérisé en ce qu'**une géométrie dudit dispositif piézoélectrique flexible est sélectionnée selon une puissance de sortie cible devant être délivrée par ledit dispositif piézoélectrique flexible pendant l'utilisation.

**5.** Dispositif piézoélectrique flexible selon la revendication 1, **caractérisé en ce que** l'épaisseur totale $t=t_s+t_f$ dudit dispositif piézoélectrique flexible est sélectionnée de manière à obtenir une amplitude de déviation prédéterminée dudit dispositif piézoélectrique flexible, où $t_f$ est l'épaisseur de film et $t_s$ est l'épaisseur de substrat, selon une fréquence de résonance cible.

**6.** Dispositif piézoélectrique flexible selon la revendication 1, **caractérisé en ce que** l'épaisseur de film, $t_f$, dudit dispositif piézoélectrique flexible est sélectionnée de manière à obtenir une capacitance prédéterminée dudit dispositif piézoélectrique flexible selon une fréquence de résonance cible.

**7.** Dispositif piézoélectrique flexible pour la récupération d'énergie selon la revendication 1, **caractérisé en ce que** l'épaisseur $t_f$ dudit film de LNT et une épaisseur $t_s$ de ladite couche de substrat flexible sont sélectionnées de manière à optimiser le couplage électromécanique efficace $k^2$ dudit dispositif piézoélectrique flexible, en fonction du rapport d'épaisseur ($\dot{\frac{t_s}{t_f}}$).

**8.** Dispositif piézoélectrique flexible pour la récupération d'énergie selon la revendication 1, **caractérisé en ce que** l'épaisseur de film, $t_f$, dudit film de LNT est sélectionnée de manière à étendre une limite de déviation dudit film de LNT pendant l'utilisation.

**9.** Dispositif piézoélectrique flexible pour la récupération d'énergie selon la revendication 1, **caractérisé en ce qu'**une orientation de cristaux de LiNbO$_3$ et/ou de LiTaO$_3$ formant ledit film de LNT est choisie de manière à optimiser la valeur de facteur de couplage de déviation $k_{23}$ dudit film de LNT.

**10.** Dispositif piézoélectrique flexible pour la récupération d'énergie selon la revendication 4, dans lequel une orientation du tenseur piézoélectrique autour de l'axe X est définie par un angle $\theta$ selon la norme IEEE, la flexion se produisant dans le plan perpendiculaire à l'axe X, et la valeur d'angle $\theta$ appartenant au groupe consistant en :

- environ 36° équivalent à (YXl)/36° ;
- environ 128° équivalent à (YXl)/128° ;
- environ 137° équivalent à (YXl)/137° ;
- environ 163° équivalent à (YXl)/163°.

**11.** Dispositif piézoélectrique flexible pour la récupération d'énergie selon la revendication 1, **caractérisé en ce que**

une largeur du dispositif est d'environ 10 mm, une longueur est comprise entre 40 mm et 100 mm et
une fréquence de résonance est comprise entre 10 Hz et 200 Hz.

**12.** Procédé de fabrication d'un dispositif piézoélectrique selon l'une quelconque des revendications 1 à 11, comprenant :

- la préparation d'un substrat de LNT ;
- une étape de nettoyage d'un substrat hôte ;
- des premières étapes de rodage et de polissage du substrat hôte au moins sur une seule des deux faces du substrat hôte ;
- une étape de dépôt d'un mince film métallique intermédiaire sur une face ;

- une étape de polissage dudit film métallique déposé ;
- une étape de collage pour le transfert du substrat de LNT préparé sur ledit substrat hôte délivrant un substrat collé.

13. Procédé de fabrication d'un dispositif piézoélectrique selon la revendication 12 dans lequel l'étape de préparation du substrat de LNT comprend :

- une étape de dépôt d'une couche métallique adhésive et d'une couche d'or sur un côté d'une plaquette de monocristal piézoélectrique ; et, après ladite étape de collage :
- une étape de préparation d'au moins un porte-à-faux sur la base dudit substrat collé ;
- une étape d'amincissement dudit substrat de LNT dudit au moins un porte-à-faux jusqu'à une épaisseur cible, $t_f$.

14. Procédé de fabrication d'un dispositif piézoélectrique selon la revendication 12, comprenant en outre :

- l'obtention d'une plaquette de substrat de LNT ;
- l'électrodépôt métallique sur ladite plaquette ;
- l'amincissement de ladite plaquette à une épaisseur cible, $t_f$.

*Figure 1*

*Figure 2*

Figure 3

Figure 4

*Figure 5*

*Figure 6*

Figure 7

Figure 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11136964 B

- US 2019190404 A

**Non-patent literature cited in the description**

- **G. CLEMENTI**. LiNbO3 films - A low-cost alternative lead-free piezoelectric material for vibrational energy harvesters. *Mechanical Systems and Signal Processing*, 2021, vol. 149, 107171